Europäisches Patentamt

European Patent Office

Office européen des brevets

(19)

(11) Veröffentlichungsnummer: **0 508 327 A2**

# (12) EUROPÄISCHE PATENTANMELDUNG

(21) Anmeldenummer: **92105812.9**

(22) Anmeldetag: **03.04.92**

(51) Int. Cl.$^5$: **G05F 3/30**

(30) Priorität: **05.04.91 DE 4111103**

(43) Veröffentlichungstag der Anmeldung:
**14.10.92 Patentblatt 92/42**

(84) Benannte Vertragsstaaten:
**AT DE FR GB IT NL**

(71) Anmelder: **SIEMENS AKTIENGESELLSCHAFT**
**Wittelsbacherplatz 2**

**W-8000 München 2(DE)**

(72) Erfinder: **Kraus, Rainer, Dr.-Ing.**
**Weidener Strasse 21**
**W-8000 München 83(DE)**
Erfinder: **Hoffmann, Kurt, Dr. Prof.**
**Nelkenweg 20**
**W-8028 Taufkirchen(DE)**

(54) CMOS-Bandabstands-Referenzschaltung.

(57) Zur Erzeugung einer weitgehend temperaturunabhängigen Referenzspannung (VR) in einer MOS-Technologie ohne zusätzliche Prozeßschritte ist eine Bandgap-Schaltung vorgesehen, bei der die Bipolartransistoren als parasitäre Transistoren (T1 bis T3, T5 bis T7, T10 bis T12) und ein erforderlicher Operationsverstärker (OP) in komplementärer MOS-Technik ausgebildet sind. Durch Kaskadieren von Bipolartransistoren (T1 bis T3; T5, T6, T10, T11) läßt sich die Referenzspannung (VR) vervielfachen, und durch Verwendung von Kompensationstransistoren (T7, T12) lassen sich die Basisströme kompensieren. Der Operationsverstärker (OP) mit p-Kanal-Eingangstransistoren (M1, M2) und einem Sourcefolger-Ausgangstransistor (M5) steuert einen Stromgenerator (M20, M21), dessen Strom (IR) in die Bipolartransistoren (T5 bis T7, T10 bis T12) gespiegelt wird. Die in das Substrat (VSUB) fließenden Kollektorströme der Bipolartransistoren (T1 bis T3; T5 bis T7, T10 bis T12) sind mit üblichen Mitteln beherrschbar.

FIG 5

Die Erfindung betrifft eine Bandabstands-Referenzschaltungsanordnung, die einen ersten Bipolartransistor mit Emitterwiderstand und einen zweiten Bipolartransistor enthält und bei der eine Differenz der Basis-Emitter-Spannungen der beiden Bipolartransistoren erzeugt und mit Hilfe eines Operationsverstärkers zur Erzeugung einer weitgehend temperaturunabhängigen Referenzspannung verarbeitet wird.

Referenzspannungen werden für vielfältige Verwendungszwecke benötigt. Gemäß ihrer Funktion hängen die Eigenschaften der gesamten Schaltung von den Eigenschaften der Referenzspannungen ab. Eine wesentliche Forderung an Referenzspannungsquellen ist deshalb ihre Unabhängigkeit von der Temperatur. Sehr genaue und nahezu temperaturunabhängige Referenzspannungen lassen sich mit Hilfe sogenannter Bandabstands- bzw. Bandgap-Schaltungen erzeugen. Eine Bandgap-Schaltung verwendet im Prinzip die Basis-Emitter-Spannung eines Transistors als Referenz, zu deren negativen Temperaturkoeffizienten zur Kompensation eine Spannung mit einem positiven Temperaturkoeffizienten addiert wird. Dazu wird bei zwei mit unterschiedlichen Strömen betriebenen Transistoren eine Differenz der Basis-Emitter-Spannungen der Transistoren gebildet.

Bandabstands-Referenzschaltungsanordnungen der eingangs genannten Art sind beispielsweise aus der Veröffentlichung U. Tietze, Ch. Schenk: "Halbleiter-Schaltungstechnik", Springer-Verlag, Berlin, 7. Aufl., 1985, Seiten 534 bis 537 bekannt. Die beschriebenen Bandabstands-Schaltungen verwenden einen Operationsverstärker, dessen Ausgang auf die eigentliche Bandgap-Schaltung rückgekoppelt ist. Grundsätzlich lassen sich Bandabstands-Referenzen mit niedriger Spannung betreiben, die im Extremfall gleich der Bandabstandsspannung ist, bei Silizium etwa 1,2 V.

Da das Prinzip der Bandgap-Schaltung auf der Kompensation der Temperaturabhängigkeit der Basis-Emitter-Spannung eines bipolaren Transistors beruht, ist für die Realisierung einer derartigen Schaltung üblicherweise eine bipolare Technologie erforderlich. Schwierigkeiten treten dann auf, wenn Bandgap-Referenzschaltungen in MOS- oder komplementären MOS-Schaltungen eingesetzt werden sollen. Neben der für diese Schaltungen erforderlichen MOS- oder CMOS-Technologie sind auch bipolare Prozeßschritte erforderlich.

Der Erfindung liegt die Aufgabe zugrunde, eine Bandabstands-Referenzspannungsschaltung anzugeben, die sich in CMOS-Technologie ohne zusätzliche bipolare Prozeßschritte realisieren läßt.

Diese Aufgabe wird bei einer Anordnung der genannten Art durch die kennzeichnenden Merkmale des Patentanspruchs 1 gelöst.

Die Erfindung hat den Vorteil, daß eine Bandabstands-Referenzschaltung in einem CMOS- bzw. MOS-Technologieprozeß realisiert werden kann, ohne daß zusätzliche Prozeßschritte erforderlich sind. Da lediglich die Bipolartransistoren als parasitäre Transistoren ausgebildet werden, ist für die Verarbeitung der erzeugten Differenz der Basis-Emitter-Spannungen dieser Transistoren der Einsatz von Bauelementen möglich, die in komplementärer MOS-Technik hergestellt sind. Auf diese Weise genießt die Schaltung die an sich bekannten Vorteile der CMOS-Technologie und einer bereitgestellten weitgehend temperaturunabhängigen Referenzspannung.

Ausgestaltungen der Erfindung sind in Unteransprüchen gekennzeichnet.

Die Erfindung wird nachfolgend anhand von in den Figuren der Zeichnung dargestellten Ausführungsbeispielen näher erläutert. Gleiche Elemente sind mit gleichen Bezugszeichen versehen. Es zeigt:

Figur 1    das Prinzip eines vertikalen parasitären pnp-Bipolartransistors bei einem n-Wannen-CMOS-Prozeß,

Figur 2    ein Prinzipschaltbild einer erfindungsgemäßen Bandgap-Schaltung,

Figur 3    ein Prinzipschaltbild einer erfindungsgemäßen Bandgap-Schaltung mit kaskadierten Bipolartransistoren,

Figur 4    ein Prinzipschaltbild eines in der erfindungsgemäßen Schaltung einsetzbaren CMOS-Operationsverstärkers und

Figur 5    ein prinzipielles Komplettschaltbild einer erfindungsgemäßen Bandgap-Referenzschaltung.

Die Ausführungsbeispiele beschränken sich auf die Realisierung einer Bandgap-Spannungsreferenzschaltung in n-Wannen-CMOS-Technologie. Es ist jedoch unmittelbar einsichtig, daß die Erfindung nicht auf eine derartige Ausführungsform beschränkt ist. Genauso gut ist ihre Realisierung in einem p-Wannen-CMOS-Prozeß sowie in üblichen MOS-Prozessen möglich.

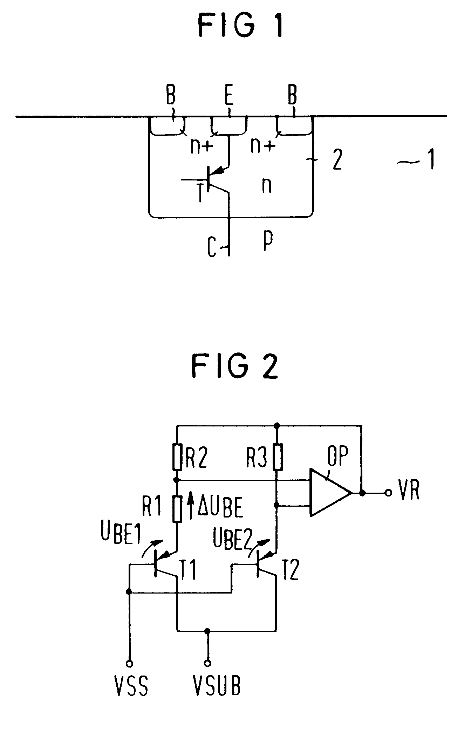

Gemäß Figur 1 ist dargestellt, wie in einem n-Wannen-CMOS-Prozeß ein parasitärer bipolarer Transistor entsteht. In einem p-leitfähigen Halbleitersubstrat 1 ist eine n-leitfähige Wanne 2 vorgesehen. Die Wanne 2 enthält höherdotierte Bereiche E vom $p^+$-Leitfähigkeitstyp und B vom $n^+$-Leitfähigkeitstyp. In einer derartigen Anordnung entsteht ein parasitärer vertikaler pnp-Bipolartransistor T, bei der das p-Substrat 1 als Kollektor, die n-Wanne 2 mit den hochdotierten Bereichen B als Basis und der $p^+$-Diffusionsbereich E als Emitter wirken.

In der Anordnung gemäß Figur 1 fließt der Kollektorstrom des parasitären pnp-Bipolartransistors in das Substrat. Grundsätzlich sind hohe Substratströme in einer integrierten MOS-Schaltung unerwünscht. Im Fall des parasitären Bipolartransistors gemäß Figur 1 ist der in das Substrat fließende Kollektorstrom jedoch tolerierbar, da die Kollektorströme für eine gesamte integrierte Schaltung auf wenige Mikroampere begrenzt werden können. Gegebenenfalls ist ein Substratvorspannungsgenerator erforderlich, wie er in vielen integrierten Schaltungen bereits eingesetzt wird, der das Substrat auf eine negative Spannung pumpt.

Das Prinzip der erfindungsgemäßen Bandabstands-Referenzschaltungsanordnung zeigt Figur 2. Zwei gemäß der Ausführungsform nach Figur 1 realisierte parasitäre Bipolartransistoren T1 und T2 sind mit ihren Basisanschlüssen an einem Bezugspotential VSS angeschlossen. Die Kollektoren der Transistoren T1 und T2 sind miteinander bzw. mit dem Substrat VSUB verbunden. Dem Emitter des Transistors T1 sind zwei in Reihe geschaltete Widerstände R1 und R2 nachgeschaltet. Dem Emitter des Transistors T2 ist ein Widerstand R3 nachgeschaltet. Die den Emittern der Transistoren T1 und T2 abgewandten Anschlüsse der Widerstände R2 und R3 sind miteinander verbunden. Der Verbindungspunkt der Widerstände R1 und R2 führt an einen Eingang eines Operationsverstärkers OP, dessen anderer Eingang am Verbindungspunkt des Emitters von T2 mit dem Widerstand R3 liegt. Der Ausgang des Operationsverstärkers OP ist mit einer Klemme VR verbunden und auf den Verbindungspunkt der Widerstände R2 und R3 rückgekoppelt. Der Operationsverstärker OP ist ebenso wie die Widerstände R1 bis R3 in üblicher MOS- bzw. komplementärer MOS-Technik ausgeführt.

Nachfolgend wird die an sich bekannte Funktionsweise einer Bandgap-Schaltung gemäß Figur 2 beschrieben. Die Ausgangsspannung an der Klemme VR des Operationsverstärkers OP stellt sich so ein, daß die Eingangsspannung an den Eingängen des Operationsverstärkers OP Null wird. Dann fällt am Emitterwiderstand R1 des Transistors T1 die Differenz $\Delta U_{BE}$ der Basis-Emitter-Spannungen $\Delta U_{BE2}$ des Transistors T2 und $U_{BE1}$ des Transistors T1 ab. Die Referenzspannung an der Klemme VR ergibt sich somit aus der Basis-Emitter-Spannung $U_{BE1}$ des Transistors T1 und der Differenz $\Delta U_{BF}$ der Basis-Emitter-Spannungen der Bipolartransistoren, die mit einem Verstärkungsfaktor 1 + R2/R1 multipliziert wird. Die Differenz $\Delta U_{BE}$ der Basis-Emitter-Spannungen der Bipolartransistoren ergibt sich andererseits aus der Temperaturspannung kT/q multipliziert mit dem natürlichen Logarithmus des Produkts aus dem Verhältnis der Kollektorströme von T2 und T1 und dem Verhältnis der Emitterflächen von T1 und T2. Darin bedeutet der Faktor k die Boltzmann-Konstante, T die absolute Temperatur und q die Elementarladung.

Die Basis-Emitter-Spannung $U_{BE1}$ des Transistors T1 besitzt einen negativen Temperaturkoeffizienten, die Differenz $\Delta U_{BE}$ der Basis-Emitter-Spannungen dagegen einen positiven Temperaturkoeffizienten. Der durch den Wert der Widerstände R1 und R2 bestimmte Verstärkungsfaktor 1 + R2/R1 wird so gewählt, daß sich der positive und der negative Temperaturkoeffizient kompensieren. Dann ist die an der Klemme VR auftretende Referenzspannung näherungsweise so groß wie der Bandabstand von beispielsweise Silizium, d.h. näherungsweise gleich 1,2 V.

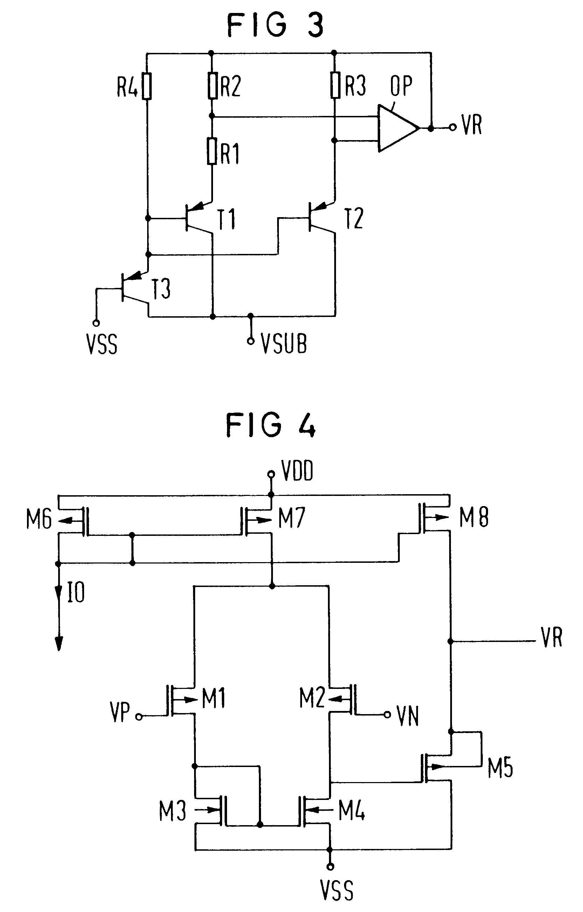

Will man, wie anhand von Figur 1 erläutert, die Kollektorströme für die gesamte Schaltung auf wenige Mikroampere begrenzen, dann darf der Kollektorstrom für jeden Transistor etwa 1 µA betragen. Bei diesem vorgegebenen Strom und höheren Temperaturen ist die Basis-Emitter-Spannung der Bipolartransistoren relativ niedrig, d.h. in der Größenordnung 500 mV. Spannungen dieser Größenordnung können als Eingangspegel üblicher CMOS-Operationsverstärker nicht hergenommen werden, ohne den Funktionsbereich des Operationsverstärkers einzuengen. Koppelkapazitäten zur Ankopplung der Basis-Emitter-Spannungen an die Eingänge des Operationsverstärkers sind aber oft unerwünscht. In einer schematisch in Figur 3 dargestellten vorteilhaften Ausführungsform der Erfindung ist deshalb vorgesehen, die an den Operationsverstärker OP anzulegenden Basis-Emitter-Spannungen zu vervielfachen.

Im Ausführungsbeispiel gemäß Figur 3 werden die Spannungen verdoppelt. Dazu ist zusätzlich zu den Elementen einer Schaltung, wie sie Figur 2 beschreibt, ein parasitärer Bipolartransistor T3 mit Emitterwiderstand R4 vorgesehen. Die Schaltung der übrigen Elemente soll aus Vereinfachungsgründen nicht wiederholt, sondern nur die Unterschiede aufgezeigt werden. So sind im Gegensatz zum Ausführungsbeispiel gemäß Figur 2 die Basisanschlüsse der Bipolartransistoren T1 und T2 nicht direkt mit dem Bezugspotential VSS verbunden. Vielmehr sind die Basisanschlüsse der beiden Transistoren T1 und T2 mit dem Emitter eines weiteren Bipolartransistors T3 verbunden, dessen Basis am Bezugspotential VSS angeschlossen ist und dessen Kollektor durch das Substrat bzw. die Substratklemme VSUB gebildet wird. Am Verbindungspunkt des Emitters von T3 und der Basen von T1 und 72 ist ein Widerstand R4 angeschlossen, dessen anderer Anschluß mit dem gemeinsamen Verbindungspunkt der Widerstände R2, R3 und der Klemme VR verbunden ist.

Die Verdopplung der Eingangspegel für den Operationsverstärker OP gemäß Figur 3 erfolgt also durch Kaskadieren der Bipolartransistoren. Statt wie in Figur 3 einen gemeinsamen Transistor T3 als Kaskadetransistor sowohl für den Transistor T1 als auch den Transistor T2 vorzusehen, können selbstverständlich auch für jeden der Transistoren T1 und T2 ein Kaskadetransistor mit zugehörigem Emitterwiderstand vorhanden sein. Selbstverständlich können durch weitere Kaskadetransistoren die Eingangspegel des Operationsverstärkers OP entsprechend der Zahl der kaskadierten Transistoren angehoben werden. Die durch zwei Kaskadetransistoren gemaß Figur 3 erzielte Pegelverdopplung für den Operationsverstärker OP hat den weiteren Effekt, daß die temperaturkompensierte Referenzspannung an der Klemme VR doppelt so hoch ist wie bei der Ausführungsform gemäß Figur 2. Bei Zimmertemperatur erreicht die Schaltung gemäß Figur 3 deshalb eine Referenzspannung an der Klemme VR von etwa 2,5 V.

Wie bereits anhand von Figur 2 erläutert, hängt die Differenz der Basis-Emitter-Spannungen der Bipolartransistoren T2 und T1 einerseits vom Verhältnis der entsprechenden Kollektorströme dieser Transistoren und andererseits vom reziproken Verhältnis der Emitterflächen der beiden Transistoren ab. Unterschiedliche Kollektorströme lassen sich beispielsweise durch in den Figuren 2 und 3 nicht eingezeichnete unterschiedliche Kollektorwiderstände einstellen. Einfacher und zweckmäßiger ist es jedoch, die Differenz der Basis-Emitter-Spannungen (bei gleichem Strom) durch unterschiedliche Wahl der Emitterflächen der Transistoren zu realisieren. Als zweckmäßig erweist es sich dabei, die Emitterfläche des Transistors T1 etwa zehnmal so groß zu wählen wie die Emitterfläche des Transistors T2. Ordnet man jedem der Transistoren T1 und T2 einen eigenen Kaskadetransistor zu, deren Emitterflächenverhältnis ebenso wie das Emitterflächenverhältnis der Transistoren T1 und T2 gewählt ist, so verdoppelt man die Spannungsdifferenz mit positivem Temperaturkoeffizienten. Man erreicht größere Emitterflächen beispielsweise durch die flächenmäßig größere Ausbildung der Emitterzone, wie sie in Figur 1 erläutert ist, oder aber durch Parallelschalten mehrerer parasitärer Bipolartransistoren.

Ein Ausführungsbeispiel für die Ausbildung des Operationsverstärkers OP zeigt Figur 4. Den eigentlichen Differenzverstärker bilden die Transistoren M1 bis M4. Die Transistoren M1 und M2 sind die Eingangstransistoren, deren Gateanschlüsse an Klemmen VP bzw. VN angeschlossen sind. Der Gateanschluß des Transistors M1 stellt dabei den nichtinvertierenden Eingang und der Gateanschluß des Transistors M2 den invertierenden Eingang des Operationsverstärkers dar. Die Sourceschlüsse der p-Kanal-Transistoren M1 und M2 sind miteinander und mit einem Ausgangsanschluß des Transistors M7 verbunden, dessen anderer Ausgangsanschluß an einer Klemme VDD mit einem Versorgungsspannungspotentialangeschlossen ist. Der Transistor M7 bildet eine Stromquelle, deren Strom durch einen Stromspiegel vorgegeben ist.

Der Stromspiegel enthält die Transistoren M6 und M7, wobei der Transistor M6 als Diode geschaltet ist. Dabei ist der Sourceanschluß des p-Kanal-Transistors M6 mit der Klemme VDD und sein Gateanschluß mit dem Drainanschluß direkt verbunden. Der Gateanschluß von M6 ist ebenfalls am Gateanschluß des p-Kanal-Transistors M7 angeschlossen.

Durch eine in Figur 4 nicht gezeigte Beschaltung, die dem Fachmann geläufig ist, wird im Ausgangskreis des Transistors M6 ein Ausgangsstrom Io eingestellt. Dieser Strom Io wird entsprechend den Geometrieverhältnissen der Transistoren M6 und M7 in den Transistor M7 gespiegelt, so daß er die Transistoren M1 und M2 versorgen kann. Die Drainanschlüsse der Transistoren M1 und M2 sind mit Lasttransistoren M3 bzw. M4 verbunden, die gemäß Figur 4 durch n-Kanal-Transistoren in Stromspiegelschaltung gebildet werden. Dazu ist der Drainanschluß des Transistors M1 mit dem Drain von M3 und den Gateanschlüssen der Transistoren M3 und M4 verbunden. Die Drainanschlüsse von M2 und M4 sind direkt miteinander verbunden. Die Sourceanschlüsse der Transistoren M3 und M4 sind gemeinsam miteinander und mit einer Klemme VSS für das Bezugspotential verbunden. Den Ausgang des Differenzverstärkers bilden die Drainanschlüsse der Transistoren M2 und M4, deren gemeinsamer Verbindungspunkt mit dem Gateanschluß eines Transistors M5 verbunden ist, der als Sourcefolger geschaltet ist. Dazu ist der p-Kanal-Transistor M5 an seinem Drain mit der Klemme VSS bzw. den Sourceanschlüssen von M3 und M4 verbunden, während die Source von M5 vom Ausgangskreis eines p-Kanal-Transistors M8 versorgt wird, der mit dem Transistor M6 einen Stromspiegel bildet. Dazu ist der Gateanschluß von M8 mit dem Gateanschluß von M6 bzw. ebenfalls mit der Gateanschluß von M7 verbunden, während der Sourceanschluß von M8 an der Klemme VDD liegt. Der Verbindungspunkt des Drainanschlusses von M8 und des Sourceanschlusses von M5 ist mit der Klemme VR verbunden, an der das Referenzpotential anliegt. Der Vollständigkeit halber sei erwähnt, daß der Bulkanschluß und der Sourceanschluß des Transistors M5 miteinander verbunden sind.

Die p-Kanal-Transistoren M1 und M2 sind aufgrund der niedrigen Eingangspegel für die Verstärkereingänge des Operationsverstärkers zweckmäßig. Mit Hilfe des nachgeschalteten p-Kanal-Sourcefolgertransistors M5 wird an der Klemme VR die Ausgangsreferenzspannung von etwa 2,5 V erreicht. Die Schaltung gemäß Figur 4 kann grundsätzlich in einer erfindungsgemäßen Schaltung eingesetzt werden. Für eine optimale Funktion sind jedoch einige Dimensionierungshinweise zu beachten. So sollte der Bias-Strom Io, dessen Erzeugung an sich jedem Fachmann geläufig ist, nahezu völlig unabhängig von der Versorgungsspannung an der Klemme VDD eingestellt werden. Auf diese Weise können rasche Schwankungen der Versorgungsspannung die Referenzspannung an der Klemme VR nicht beeinflussen. Außerdem muß die Höhe des Stroms Io, die die Höhe der Ströme in den Transistoren M7 und M8 bestimmt, an die Schaltung angepaßt sein. Der Strom durch den Transistor M8 muß durch Wahl des Stromspiegelverhältnisses von M6 und M8 bzw. des Stroms Io so eingestellt sein, daß er mindestens so groß ist wie die Summe der Emitterströme der parasitären Bipolartransistoren. Andererseits dürfen die Stromquellenströme nicht zur Zerstörung der Transistoren führen.

Grundsätzlich kann die Referenzspannung an der Klemme VR zur Einstellung und Steuerung des Bias-Stroms Io der Stromquelle eingesetzt werden. Eine direkte Steuerung hätte jedoch eine positive Rückkopplung für die gesamte Schaltung zur Folge. Eine negative Rückkopplung, mit der die Anordnung stabil arbeitet, läßt sich erreichen, indem dem Operationsverstärker eine Inverterstufe nachgeschaltet wird. Eine derartige Inverterstufe erfordert jedoch Maßnahmen, die eine Beeinflussung der Referenzspannung durch Störungen der Versorgungsspannung vermeidet.

Bei der Dimensionierung eines Operationsverstärkers gemäß Figur 4 in einer Schaltung gemäß Figur 3 ist zu beachten, daß die Widerstände R1 bis R4 vergleichsweise hochohmig sein müssen. Auf integrierten Schaltungen realisierte Widerstände beanspruchen beanspruchen relativ viel Chipfläche, beispielsweise sind für die gemäß Figur 3 erforderlichen Megaohmwiderstände einige Zentimeter Polysiliziumbahnen erforderlich.

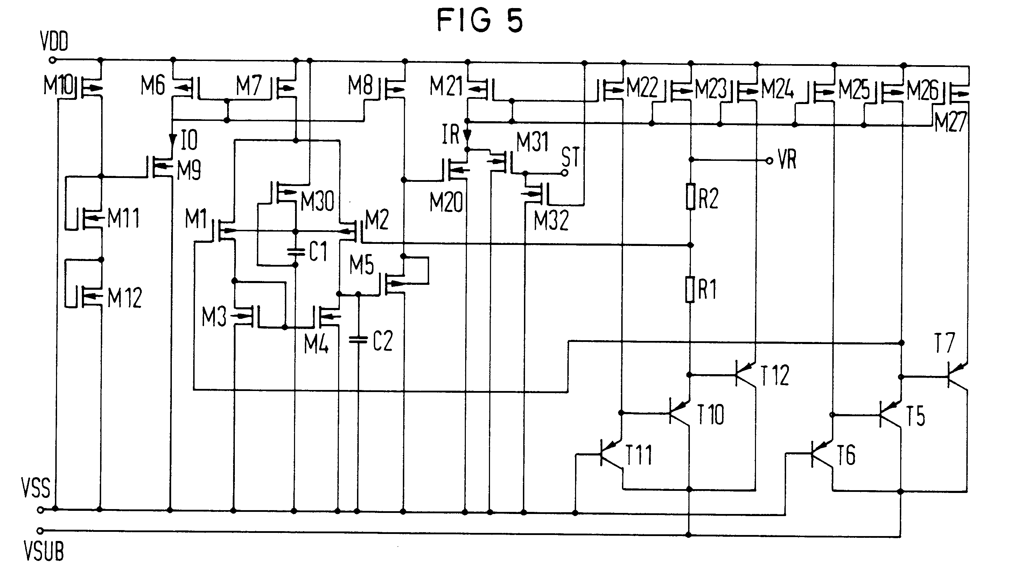

Figur 5 gibt ein komplettes Prinzipschaltbild einer erfindungsgemäßen Bandabstands-Referenzschaltungsanordnung an, die unter Beachtung der zuvor aufgestellten Dimensionierungsvorschriften optimiert ist.

Der Operationsverstärker enthält die Transistoren M1 bis M8, wie sie anhand von Figur 4 beschrieben sind. Die Gateanschlüsse der Transistoren M1 und M2 als Eingänge des Operationsverstärkers werden von Anschlüssen der parasitären Bipolar-Transistoranordnung gesteuert. Die erste Eingangsspannung des Operationsverstärkers wird mit Hilfe der Transistoren T5 und T6 erzeugt, denen in Figur 3 die Transistoren T2 und T3 entsprechen. T5 und T6 sind kaskadiert. Die zweite Eingangsspannung des Operationsverstärkers wird mit Hilfe der Transistoren T10 und T11 erzeugt, die ebenfalls gemäß den Transistoren T1 und T3 nach Figur 3 kaskadiert sind. Im Emitterkreis des Transistors T10 liegen die beiden in Reihe geschalteten Widerstände R1 und R2. Der Verbindungspunkt dieser beiden Widerstände ist auf den Gateanschluß von M2 geschaltet, während der Emitteranschluß des Transistors T5 auf den Gateanschluß des Transistors M1 geschaltet ist.

Im Ausführungsbeispiel gemäß Figur 5 ist vorgesehen, daß die Emitterflächen der Transistoren T10 und T11 jeweils zehnmal so groß sind wie die Emitterflächen der Transistoren T5 und T6. Selbstverständlich können auch andere Verhältnisse eingestellt werden. Den Transistoren T10 und T11 ist ein weiterer parasitärer Bipolartransistor T12 und den Transistoren T5 und T6 ein weiterer parasitärer Bipolartransistor T7 zugeordnet. Der Basisanschluß des Transistors T12 liegt am Emitter des Transistors T10 und der Basisanschluß des Transistors T7 liegt am Emitter des Transistors T5. Die Kollektoren der Transistoren T7 und T12 sind gemeinsam mit den Kollektoren der anderen Bipolartransistoren am Substrat der Halbleiterscheibe angeschlossen, das durch die Klemme VSUB symbolisiert ist.

Den Emittern der Transistoren T5 bis T7 und T10 bis T12 werden Ströme eingeprägt, die gemäß Figur 5 mit Hilfe einer Stromspiegelanordnung aus den Transistoren M21 bis M27 erzeugt werden. Die Transistoren dieser Stromspiegelschaltung sind als p-Kanal-MOS-Transistoren ausgebildet. Sämtliche Transistoren der Stromspiegelschaltung sind mit ihren Sourceanschlüssen an der Klemme VDD angeschlossen. Beim Transistor M21 sind der Gate- und Drainanschluß direkt miteinander verbunden und dieser Koppelpunkt ist weiterhin auf die Gateanschlüsse der Transistoren M22 bis M27 geführt. Entsprechend speisen die Drainanschlüsse der Transistoren M22 bis M27 die in diese Transistoren gespiegelten Ströme in die Emitter der Transistoren T5 bis T7, T11 und T12 sowie über die Widerstände R1 und R2 in den Emitter des Transistors T10 ein. Am Verbindungspunkt des Widerstands R2 mit dem Drainanschluß des Transistors M23 liegt die Klemme VR mit der temperaturunabhängigen Referenzspannung.

Die Stromspiegelschaltung mit den Transistoren M21 bis M27 wird durch den Transistor M20 zu einem Stromgenerator ergänzt, der vom Sourcefolgertransistor M5 des Operationsverstärkers an seinem Gateanschluß gesteuert ist. Der Ausgangskreis des n-Kanal-MOS-Transistors M20 liegt dabei in Serie zum Ausgangskreis des Transistors M21. Dazu sind die Drainanschlüsse dieser beiden Transistoren miteinander verbunden, während der Sourceanschluß des Transistors M20 am Bezugspotential VSS liegt. Durch die Ausgangskreise der Transistoren M20 und M21 fließt deshalb der Strom IR. Die Stromspiegelschaltung mit den Transistoren M21 bis M27 wird in der Ausführungsform gemäß Figur 5 so dimensioniert, daß jeder Bipolartransistor mit annähernd dem gleichen Strom, der gleich dem Strom IR ist, versorgt wird.

In der Schaltung gemäß Figur 5 sind Widerstände nur noch durch den Spannungsteiler aus den Widerständen R1 und R2 als ohmsche Widerstände zu realisieren. Das bedeutet, daß die erfindungsgemäße Schaltung für die Integration nur noch mit dem Minimum von zwei ohmschen Widerständen auskommt und somit erhebliche Chipfläche eingespart wird.

Die Verwendung von sechs parasitären Bipolartransistoren bietet gegenüber der Ausführungsform gemäß Figur 3 weitere Vorteile. Zu ergänzen ist dabei, daß der Transistor T12 die gleiche Emitterfläche aufweist wie die Transistoren T10 und T11, d.h. im Ausführungsbeispiel die zehnfache Emitterfläche der Emitterflächen der Transistoren T5 bis T7. Zweckmäßigerweise werden die Bipolartransistoren T10 bis T12 aus je zehn parallelgeschalteten parasitären Bipolartransistoren realisiert.

Für die Funktion der Bandgap-Referenzschaltungsanordnung sind, wie bereits erwähnt, die Basis-Emitter-Spannungen der parasitären Bipolartransistoren T10, T11 sowie T5, T6 entscheidend. Die Basis-Emitter-Spannung jedes dieser Transistoren wird dabei durch seinen Kollektorstrom mitbestimmt. Andererseits ist der Kollektorstrom gleich der Differenz des Emitter- bzw. Basisstroms des zugeordneten Transistors. Falls, wie angenommen, der eingeprägte Strom IR gleich dem Emitterstrom des Transistors ist, muß der Einfluß des Basisstroms dieses Transistors auf das Temperaturverhalten der Basis-Emitter-Spannung mit berücksichtigt werden. Da die Stromverstärkung der Bipolartransistoren sehr gering ist und in der Größenordnung Eins liegt, ist der Basisstrom nicht vernachlässigbar. Die Stromverstärkung selbst ist stark temperaturabhängig, zudem kann ihr Wert stark streuen.

Aus diesem Grund sorgen die Transistoren T12 bzw. T7 für eine Kompensation der Basisströme der Transistoren T10 bzw. T5. In der erfindungsgemäßen Anordnung gemäß Figur 5 setzt sich der Emitterstrom der für die Bandgap-Schaltung relevanten Transistoren T5, T6, T10 und T11 zusammen aus dem Strom IR bzw. dem durch die Stromspiegelschaltung M21 bis M27 erzeugten jeweiligen Emitterströmen und dem Basisstrom des jeweils benachbarten Transistors. Das bedeutet unter der Annahme, daß die Emitterströme gleich dem eingeprägten Strom IR sind, daß der Kollektorstrom jedes für die Bandgap-Funktion relevanten Transistors ungefähr gleich dem eingeprägten Strom IR ist, weil die Stromverstärkungen benachbarter Transistoren nicht stark voneinander abweichen. Aus diesem Grund haben die in die Transistoren fließenden Basisströme keinen Einfluß auf das Temperaturverhalten der jeweiligen Basis-Emitter-Spannung.

Für die temperaturunabhängige Referenzspannung an der Klemme VR gilt deshalb, daß sich ihr Wert aus der doppelten Basis-Emitter-Spannung des Transistors T10 bzw. T11 durch Addition mit dem Produkt aus dem Referenzstrom IR und der Summe der Widerstände R1 und R2 ergibt.

In der Ausführungsform gemäß Figur 5 besitzt die erfindungsgemäße Schaltung keine Offsetkompensation, aber selbstverständlich gehört eine derartige Offsetkompensation in den Rahmen der Erfindung. Gemäß Figur 5 wirkt sich ein Offset des Operationsverstärkers dahingehend aus, daß die doppelte Differenz der Basis-Emitter-Spannungen der Bipolartransistoren um die Offsetspannung erhöht wird, wobei dieser Ausdruck mit dem Verstärkungsfaktor 1 + R2/R1 multipliziert wird. Dementsprechend kann die Referenzspannung vom gewünschten Wert abweichen. Da andererseits die doppelte Differenz der Basis-Emitter-Spannungen aufgrund der kaskadierten Bipolartransistoren benutzt wird, ist der erforderliche Verstärkungsfaktor 1 + R2/R1 nur halb so groß wie bei einer Lösung, die entsprechend Figur 2 nur eine Differenz der Basis-Emitter-Spannungen zur Verfügung hat. Aus diesem Grund sind die vom Offset des Operationsverstärkers verursachten Abweichungen von der idealen Referenzspannung auf die Hälfte reduziert. Sollten sich die vom Verstärkeroffset verursachten Abweichungen der Referenzspannung von der idealen Referenzspannung als störend erweisen, kann selbstverständlich mit Hilfe von an sich bekannten Maßnahmen eine Kompensation des Verstärkeroffsets vorgesehen werden.

In der Ausführungsform gemäß Figur 5 wird anstelle einer Kompensation des Verstärkeroffsets eine Minimierung dieses Offsets durch entsprechende Dimensionierung der Verstärkertransistoren erreicht. Die vier wesentlichen Transistoren M1 bis M4 des Operationsverstärkers haben große geometrische Abmessungen, damit geometrische Toleranzen nur noch geringe Auswirkungen auf die Transistorparameter haben. Das Verhältnis von Kanalweite zu Kanallänge der beiden Eingangstransistoren M1 und M2, die von den Bipolartransistor-Ausgängen gesteuert werden, ist zweckmäßigerweise möglichst groß, da dadurch die nicht von Streuungen der Temperaturspannung verursachten Offsetanteile reduziert werden. Außerdem wird die Gleichtaktunterdrückung verbessert. Für die Stromspiegeltransistoren M3 und M4 im Lastkreis der Eingangstransistoren M1 und M2 ist dagegen ein kleines Verhältnis von Kanalweite zu Kanallänge vorteilhaft, da dadurch der Einfluß der Streuungen der Temperaturspannung auf den Strom minimiert wird. Allerdings ist bei dieser Anordnung der Spielraum für die Transistoren M3 und M4 gering, da mit Verkleinern des Verhältnisses von Kanalweite zu Kanallänge die für den eingeprägten Strom erforderliche Gate-Source-Spannung zunimmt. Diese muß aber klein bleiben, damit die Transistoren M1 und M2 in Sättigung arbeiten.

Aufgrund der vorstehend erläuterten Dimensionierungshinweise wird das Verhältnis der Kanalweite zu Kanallänge der Transistoren M1 und M2 vorzugsweise auf etwa 20 eingestellt, während das entsprechende Verhältnis der Transistoren M3 und M4 auf etwa 1, vorzugsweise etwa 10:9 eingestellt wird. Die Kanalweite von M1 bzw. M2 kann etwa 200 $\mu$m betragen, während die Kanalweite von M3 bzw. M4 etwa 20 $\mu$m, d.h. in der Größenordnung um den Faktor 10 geringer, betragen kann.

Vorzugsweise wird das Layout für die vier Verstärkertransistoren M1 bis M4 möglichst symmetrisch ausgeführt. Dabei kann es sich als zweckmäßig erweisen, jeden der Transistoren aus jeweils zwei parallelgeschalteten Transistoren zu realisieren, wobei diese jeweils diagonal versetzt angeordnet und kreuzweise verdrahtet sein sollen. Auf diese Weise lassen sich ortsabhängige Parameterstreuungen durch Mittelung kompensieren.

In der Ausführungsform gemäß Figur 5 ist der Biasstrom Io für den Operationsverstärker unkritisch, da der Verstärkerausgang nur noch durch den Transistor M20 kapazitiv belastet ist. Aus diesem Grund wird der in die Transistoren M7 und M8 zu spiegelnde Strom Io mit Hilfe der mit ihren Ausgangskreisen in Reihe geschalteten Transistoren M6 und M9 erzeugt. Der n-Kanal-Transistor M9 ist an seiner Source mit der Klemme VSS für das Bezugspotential und an seinem Gateanschluß mit dem Abgriff eines Spannungsteilers verbunden. Dieser Spannungsteiler wird durch die Transistoren M10 bis M12 gebildet, die mit ihren Ausgangskreisen in Reihe geschaltet sind. Dabei sind die n-Kanal-MOS-Transistoren M11 und M12 als Diode geschaltet und der p-Kanal-Transistor M10 mit seinem Gateanschluß an der Klemme VSS angeschlossen. Der Verbindungspunkt der Ausgangskreise der Transistoren M10 und M11 steuert das Gate des Transistors M9.

Aufgrund der Transistorkenngrößen besteht für den Biasstrom Io noch ein absoluter erlaubter oberer Grenzwert, während der Strom auf der anderen Seite grundsätzlich beliebig klein werden darf. Je geringer der Biasstrom Io wird, umso mehr verringert die Schaltgeschwindigkeit des Operationsverstärkers. Da Temperaturänderungen auf der anderen Seite nicht sehr rasch erfolgen, sind die Anforderungen an die Regelgeschwindigkeit aber gering. Für den Strom Io ergibt sich ein Wert, der etwa dem halben Stromverstärkungsfaktor von M9 multipliziert mit dem Quadrat der Einsatzspannung der MOS-Transistoren entspricht. Die Transistoren für den Stromgenerator des Biasstroms Io werden zweckmäßig so dimensioniert, daß Änderungen der Versorgungsspannung an der Klemme VDD nur noch einen vernachlässigbaren Einfluß haben. Nach den Designparametern für die erfindungsgemäße Schaltung beträgt Io etwa 1 $\mu$A.

Der Substrat- oder Bulkanschluß, also die Wanne der Transistoren M1 und M2 kann mit den Sourceanschlüssen dieser Transistoren verbunden sein. Im Ausführungsbeispiel gemäß Figur 5 wird der Substratanschluß beider Transistoren jedoch auf das Versorgungspotential an der Klemme VDD gelegt, da sich die dadurch bedingte Erhöhung der Einsatzspannung vorteilhaft auf die Funktion des Operationsverstärkers auswirkt. Konkret ist ein p-Kanal-MOS-Transistor M30 vorgesehen, dessen Source an VDD, dessen Drain an den Substratanschlüssen der Transistoren M1 und M2 und dessen Gateanschluß an der Klemme VSS mit dem Bezugspotential liegt. Weiterhin ist eine Kapazität C1 zwischen den gemeinsamen Verbindungspunkt der Substratanschlüsse der Transistoren M1 und M2 sowie des Drainanschlusses des Transistors M30 und andererseits die Klemme VSS geschaltet. Der Transistor M30 ist als Hochohmtransistor ausgelegt und die Kapazität C1 in der Größenordnung von 10 pF ist als zusätzliche Stützkapazität implementiert. Durch die Kombination des Transistors M30 mit der Kapazität C1 ändert sich die Spannung am gemeinsamen Substratanschlußknoten der Transistoren M1 und M2 nur langsam. Die Anbindung dieses Knotens an die Klemme VDD, die zu einer Erhöhung der Einsatzspannung der Transistoren M1 und M2 führt, ermöglicht größere Pegelhübe an den Drainknoten der Transistoren M1 und M2, ohne daß diese Transistoren ihren Sättigungsbereich verlassen.

Gemäß Figur 5 ist der gemeinsame Verbindungspunkt der Drainanschlüsse von M2 und M4 mit dem Gateanschluß des Transistors M5, der den Ausgang des Operationsverstärkers bildet, über eine Kapazität C2 mit der Klemme VSS verbunden. Diese Kapazität hat die Aufgabe, eine eventuelle Schwingungstendenz infolge möglicher Rückkopplungen zu unterdrücken.

Schließlich sind zwei weitere Transistoren M31 und M32 vorgesehen, die vom n-Kanal-MOS-Typ sind und mit ihren Sourceanschlüssen an der Klemme VSS liegen. Der Drainanschluß von M31 ist am Verbindungspunkt der Drainanschlüsse der Transistoren M20 und M21 angeschlossen, während der Gateanschluß des Transistors M31 mit einer Klemme ST und dem Drainanschluß des Transistors M32 verbunden ist. Der Gateanschluß von M32 liegt an der Klemme VDD. Die beiden Transistoren M31 und M32 sind für den Fall vorgesehen, daß die erfindungsgemäße Schaltungsanordnung beim Anlegen der Versorgungsspannung an die Klemme VDD wegen ungünstiger Anfangsbedingungen nicht von selbst in den eingeschwungenen Betriebszustand gelangt. Ein kurzer Impuls an der Klemme ST aktiviert in diesem Fall die erfindungsgemäße Schaltung gemäß Figur 5.

Bei der Realisierung benötigen die beiden Widerstände R1 und R2 die meiste Chipfläche. Sie können beispielsweise aus 1,5 $\mu$m Breiten und insgesamt 36.000 $\mu$m langen Polysiliziumbahnen realisiert werden. Möglich ist die Zusmmenfassung mehrerer p-Kanal-MOS-Transistoren in einer gemeinsamen Wanne. Unter der getroffenen Voraussetzung, daß die Transistoren T10 bis T12 die zehnfache Emitterfläche gegenüber den Transistoren T5 bis T7 haben und daß der Verstärkungsfaktor der Schaltung 1 + R2/R1 gleich 10 gewählt wird, ergibt sich für die Basis-Emitter-Spannungen der Transistoren T10 bzw. T11 eine linear mit der Temperatur fallende Gerade, während für die Differenz der Basis-Emitter-Spannungen der beiden parasitären Bipolar-Transistoranordnungen eine linear mit der Temperatur steigende Gerade auftritt. Die Kompensation beider Temperaturabhängigkeiten ist sehr gut und es ergibt sich eine von der Temperatur unabhängige konstante Referenzspannung der Größenordnung 2,55 V.

Die Abweichungen vom idealen Wert der Referenzspannung infolge des gemäß Figur 5 nicht kompensierten Verstärkeroffsets sind kleiner als ± 50 mV. Langsame Änderungen der Versorgungsspannung im Bereich von 4 V bis 6 V haben keinen Einfluß auf die Referenzspannung. Bei schnellen Schwankungen der Versorgungsspannung an der Klemme VDD ergibt sich eine geringe Störung, die vor allem bei periodischen Schwankungen auftritt. Allerdings ist diese Störung kleiner als 20 mV, wenn die Versorgungsspannung um 1 V schwankt. Der Stromverbrauch einer erfindungsgemäßen Schaltung gemäß Figur 5 beträgt etwa 10 bis 12 $\mu$A, von denen etwa 5 bis 6 $\mu$A über die Bipolartransistoren ins Substrat fließen. Selbst wenn das Substrat mit Hilfe eines Substratvorspannungsgenerators auf negative Spannung gepumpt wird, ist dieser Substratstrom vertretbar.

**Patentansprüche**

1. Bandabstands-Referenzschaltungsanordnung, die einen ersten Bipolartransistor (T1) mit Emitterwiderstand (R1, R2) und einen zweiten Bipolartransistor (T2) enthält und bei der eine Differenz der Basis-Emitter-Spannungen ( $U_{BE}$) der beiden Bipolartransistoren (T1, T2) erzeugt sowie mit Hilfe eines Operationsverstärkers (OP) zur Erzeugung einer weitgehend temperaturunabhängigen Referenzspannung verarbeitet wird,
**dadurch gekennzeichnet,**
daß als Bipolartransistoren (T1 bis T3; T5 bis T7, T10 bis T12) parasitäre Transistoren vorgesehen sind und der Operationsverstärker (OP) in MOS-Technik ausgebildet ist.

2. Anordnung nach Anspruch 1,
**dadurch gekennzeichnet,**
daß ein parasitärer Bipolartransistor (T1 bis T3, T5 bis T7, T10 bis T12) bei einer n-leitfähigen Wanne in einer komplementären MOS-Technologie durch ein p-leitfähiges Diffusionsgebiet in der n-leitfähigen Wanne als Emitter, die n-leitfähige Wanne als Basis und ein Substratgebiet als Kollektor ausgebildet ist.

3. Anordnung nach Anspruch 1 oder 2,
**dadurch gekennzeichnet,**
daß die Bipolartransistoren (T1, T2; T5, T10) jeweils mit mindestens einem weiteren parasitären Bipolartransistor (T3; T6, T11) kaskadiert sind, wozu die Basisanschlüsse des ersten oder zweiten Bipolartransistors (T1, T2; T5, T10) mit dem Emitter des jeweils weiteren Bipolartransistors (T3; T6, T11) verbunden sind und die Kollektoren gemeinsam durch das Substratgebiet gebildet sind.

4. Anordnung nach Anspruch 3,
**dadurch gekennzeichnet,**
daß die jeweils weiteren Bipolartransistoren (T3; T6, T11) zu einem weiteren Bipolartransistor zusammengefaßt sind.

5. Anordnung nach einem der Ansprüche 1 bis 4,
**dadurch gekennzeichnet,**
daß dem ersten und zweiten Bipolartransistor (T5, T10) jeweils ein parasitärer bipolarer Kompensationstransistor (T7, T12) vorgeschaltet ist, dessen Basis mit dem Emitter des zugeordneten ersten oder zweiten Bipolartransistors (T5, T10) verbunden ist.

6. Anordnung nach einem der Ansprüche 1 bis 5,
**dadurch gekennzeichnet,**
daß zumindest ein Teil der Bipolartransistoren (T10 bis T12) durch jeweils die Parallelschaltung mehrerer parasitärer Bipolartransistoren ausgebildet ist.

7. Anordnung nach einem der Ansprüche 1 bis 6,
**dadurch gekennzeichnet,**
daß der Operationsverstärker (OP) p-Kanal-MOS-Transistoren als Eingangstransistoren und einen p-Kanal-MOS-Sourcefolger als Ausgangstransistor aufweist.

8. Anordnung nach Anspruch 7,
**dadurch gekennzeichnet,**
daß der Operationsverstärker (OP) einen Stromgenerator (M20, M21) zur Erzeugung eines Referenzstroms (IR) steuert, der in jeden parasitären Bipolartransistor gespiegelt wird.

9. Anordnung nach Anspruch 7 oder 8,

**dadurch gekennzeichnet,**
daß der Substratanschluß bzw. die Wanne der beiden p-Kanal-Eingangstransistoren(M1, M2) des Operationsverstärkers (OP) über einen hochohmigen Transistor (M30) mit einem Versorgungspotential (VDD) bzw. über eine Stützkapazität (C1) mit einem Bezugspotential (VSS) verbunden ist.

10. Anordnung nach einem der Ansprüche 7 bis 9,
**dadurch gekennzeichnet,**
daß eine Startschaltung (M31, M32, ST) vorgesehen ist, mit der über einen an einem Starttransistor (M31) anzulegenden Startimpuls der Stromgenerator (M20, M21) aktivierbar ist.

11. Anordnung nach einem der Ansprüche 7 bis 10,
**dadurch gekennzeichnet,**
daß die Eingangstransistoren (M1, M2) und diesen zugeordnete komplementäre Lasttransistoren (M3, M4) des Operationsverstärkers (OP) weitgehend symmetrisch ausgelegt sind und große geometrische Abmessungen haben, wobei das Verhältnis aus Kanalweite zu Kanallänge der Eingangstransistoren (M1, M2) >10 und das Verhältnis aus Kanalweite zu Kanallänge der komplementären Lasttransistoren (M3, M4) >1 gewählt ist.

# FIG 1

# FIG 2

# FIG 3

# FIG 4

FIG 5

EP 0 508 327 A2